Europäisches Patentamt

(19) European Patent Office

Office européen des brevets

(11) Publication number: **0 031 226**

**B1**

(12) **EUROPEAN PATENT SPECIFICATION**

(45) Date of publication of patent specification: **10.12.86**

(21) Application number: **80304497.3**

(22) Date of filing: **12.12.80**

(51) Int. Cl.⁴: **G 11 C 8/00,** G 11 C 11/40, H 03 K 19/08

(54) **A decoder circuit.**

(30) Priority: **21.12.79 JP 166593/79**

(43) Date of publication of application: **01.07.81 Bulletin 81/26**

(45) Publication of the grant of the patent: **10.12.86 Bulletin 86/50**

(84) Designated Contracting States: **DE FR GB**

(56) References cited: **US-A-4 007 451**

**IBM TECHNICAL DISCLOSURE BULLETIN, vol. 20, no. 11A, April 1978, pages 4409-4411, New York (USA); V. MARCELLO et al.: "Decode addressing circuit."**

**IBM TECHNICAL DISCLOSURE BULLETIN, vol. 18, no. 9, February 1976, pages 2818-2819, New York (USA); H. SCHETTLER: "Bipolar bootstrap circuit."**

(73) Proprietor: **FUJITSU LIMITED 1015, Kamikodanaka Nakahara-ku Kawasaki-shi Kanagawa 211 (JP)**

(72) Inventor: **Isogai, Hideaki 11-13, Minamisawa 4-chome Higashikurume-shi Tokyo, 180-03 (JP)**
Inventor: **Takahashi, Yukio 528, Kozuhara Ibuki-cho Sakata-gun Shiga, 521-04 (JP)**

(74) Representative: **Sunderland, James Harry et al HASELTINE LAKE & CO Hazlitt House 28 Southampton Buildings Chancery Lane London WC2A 1AT (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The present invention relates generally to decoder circuits, and is more particularly concerned with decoder circuits effective for use in word line selection within semiconductor memory devices.

A so-called multi-emitter type decoder circuit, for example, has a resistor connected to the base of a word line driver (transistor) when used for word line selection in a semiconductor memory device. Hence, when the load capacitance of a line connected to the emitter of this word driver is large, as in the case of a word line, a large current must be passed through the base of the word driver through the resistor connected to the base upon selection of the word line connected to the word driver, since a large charging current must be supplied to the word line being selected, at which time the level of the base voltage of the word driver connected to the selected word line becomes high.

However, because the resistance of the above-mentioned resistor is large, the resistor together with the load capaitance provides a long time constant, slowing down the rising characteristic of the base voltage of the word driver.

One method of improving the rising characteristic of the base voltage is to reduce the resistance of the above-mentioned resistor; however, this results in increased power consumption. Another method of sharpening the rise in the rising characteristic of the base voltage is to reduce word line capacitance, but, of course, word line capacitance cannot be reduced arbitrarily.

US—A—4 007 451 discloses à decoder circuit for use in a monolithic information store. The circuit has an output emitter follower the output signal of which controls a word line transistor. The output signal value depends upon the value of the logic output of an AND gate constituted by a multi-emitter transistor. A pnp transistor is connected, in series with a resistor, between a voltage source and the output emitter follower.

According to the present invention there is provided a decoder circuit, having an output gate with an emitter follower output driver for selectively driving an output line of the decoder circuit in dependence upon a logic input supplied to the output gate, and current switching means, comprising a PNP transistor, electrically connected between a voltage source and the base of the output driver, for switching current from the voltage source to the base of the output driver when the logic input has a value indicating that the output line is to be driven, characterised in that the current switching means further comprises a constant voltage maintaining means including a transistor and a resistor connected in parallel, the base of the said transistor being connected to the base of the PNP transistor to stabilise the current fed to the base of the output driver.

An embodiment of the present invention can provide a decoder circuit in which the above-described problems have been overcome.

An embodiment of the present invention can provide a decoder circuit of a multi-emitter type in which each of a plurality of output gates comprises an inverter for inverting the output of a logic circuit provided for the output gate, a constant current source that forms a current switch when taken together with a first resistor which acts as a load on the inverter, a transistor that acts as a constant voltage source, and the inverter, and a driving transistor that supplies current to the base of the output stage transistor that is controlled by the output of the inverter, and a parallel circuit having a second resistor connected between the driving transistor and a biasing circuit, and a diode for limiting the voltage , between the terminals of the second resistor, so that when the above logic circuit generates a low-level output, the bias level of the biasing circuit is applied to the base of the output stage transistor as low-level, and when the logic circuit generates a high-level the driving transistor is turned ON and a base current is directly supplied to the output stage transistor from the power source.

In a decoder circuit embodying the present invention, the operational characteristic during rise of a word line can be made to have a sharper rise pattern (faster operational speed).

Reference is made by way of example, to the accompanying drawings, in which:—

Figure 1 is a schematic circuit diagram illustrating one example of a conventional decoder circuit;

Figure 2 is a graph illustrating an operational characteristic of the decoder circuit of Figure 1;

Figure 3 is a schematic circuit diagram of a two-input decoder circuit embodying the present invention;

Figure 4 is a graph illustrating an operational characteristic of the decoder circuit of Figure 3;

Figure 5 is a more general circuit diagram of the decoder circuit of Figure 3;

Figure 6 is a schematic circuit diagram showing the decoder circuit of Figure 5 applied as a decoder driver in a semiconductor memory device;

Figure 7 is a schematic circuit diagram of another decoder circuit embodying the present invention; and

Figure 8 is a schematic circuit diagram of a two-step decoder provided with a decoder circuit embodying the present invention.

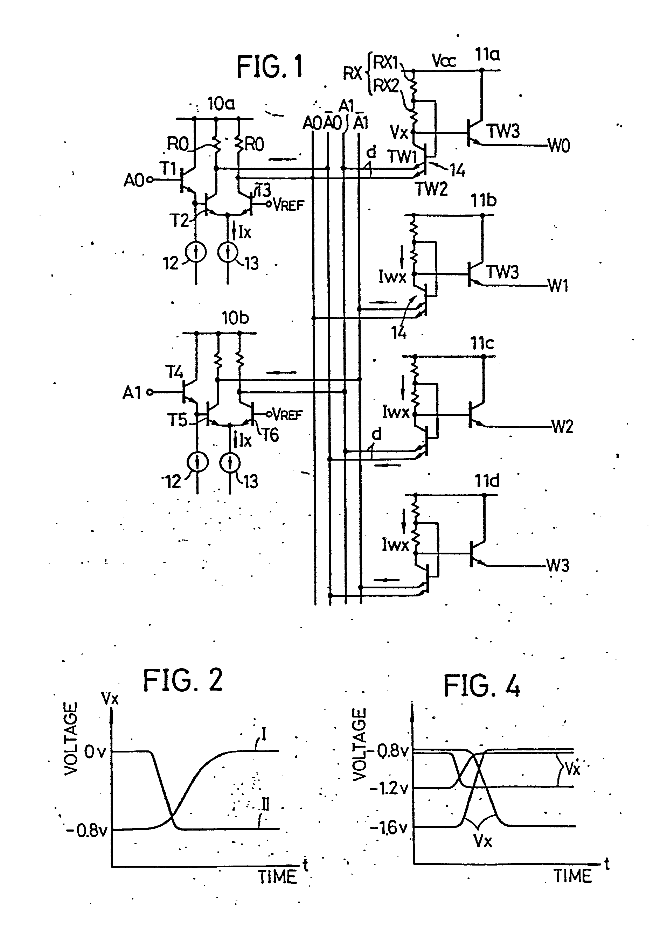

A conventional decoder circuit as used in a word signal selection circuit within a semiconductor memory circuit, is shown in Figure 1. The decoder circuit of Figure 1 is of the so-called multi-emitter type, and in order to simplify the description, a case where there are only two inputs (A0 and A1) to the decoder circuit is shown as an example.

Input gates 10a and 10b comprise transistors T1 to T3, and transistors T4 to T6, respectively, and each has two load resistors R0, and constant current sources 12 and 13. The input gates 10a and 10b from signals A0 and A1, and inverted signals $\overline{A0}$ and $\overline{A1}$, from the input signals A0 and A1 respectively supplied as input signal bits A0 and A1. On the other hand, each output gate 11a to 11d comprises multi-emitter type tansistors TW1 and TW2 which form an AND-circuit 14, a load resistor RX (divided into resistors RX1 and RX2), and an output stage transistor (word driver TW3. The output gates 11a to 11d operate on the basis of respective pairs of signals selected from the four signals A0, A1, $\overline{A0}$ and $\overline{A1}$, that is, A0 and A1, A0 and $\overline{A1}$, $\overline{A0}$ and A1, and $\overline{A0}$ and $\overline{A1}$, and each generates a high-level output when the two selected signals input thereto are both of high level.

In this decoder circuit, one of the output gates 11a to 11d generates a high-level output, in dependence upon the combination of the signal levels of the inputs A0 and A1, and therefore, in this particular example, one of words lines W0 to W3, is selected to be of high level.

Hence, when the levels of both the inputs A0 and A1 are high, the transistors T2 and T5 (indicated by oblique lines) of the respective input gates 10a and 10b turn ON, and a current Iwx respectively flows from the transistors TW2 of output gates 11c and 11d and from both transistors TW1 of the output gates 11b and 11c.

The current Iwx is given by equation (1) below, when the current which flows through the load resistors R0 is designated by I1 and Ix is the current flowing to constant current source 13.

$$Iwx=2(Ix-I1)/3 \qquad (1)$$

Accordingly, the output voltage Vx of an AND circuit 14 is given by equation (2) below, where Vcc is a power source voltage.

$$Vx=Vcc-Iwx \ (RX1+RX2) \qquad (2)$$

The level of Vx becomes low with respect to the transistors TW3 of the output gates 11b to 11d (since Iwx is flowing), and thus turns the transistors TW3 of these gates into a non-selected state, which results in a non-selection of the word lines W1 to W3.

On the other hand, the transistors TW1 and TW2 of the output gate 11a are provided with a high level voltage at their emitter junctions, and therefore, the current Iwx does not flow from the transistor TW1 (or TW2). Consequently, the potential Vx becomes:

$$Vx\cong Vcc \qquad (3)$$

and the level of the word line W0 becomes high, because the transistor TW3 is turned into a selected state by the above high-level voltage Vx. When the levels of the input signals A0 and A1 change, the level of another input gate becomes high, and accordingly another specific word line is selected.

However, since the resistor RX (RX=RX1+RX2) is connected to the base of a transistor TW3 of an emitter-follower, when the load capacitance connected to the emitter of TW3 is large, as in a case in which that emitter is connected to a word line, it becomes necessary to supply a large charging current through the word line upon selection of that line at the time at which the level of the potential Vx is high. Accordingly, it becomes necessary to pass a large base current through the resistor RX to the base of the transistor TW3; however, because the resistance of the resistor RX is large, this resistor together with the load capacitance, results in a long time-constant being formed. Thus, the rising waveform of the base potential Vx becomes such as is shown by curve I of Figure 2, having a slow rising characteristic.

Curve II in Figure 2 shows the fall time characteristic of the base voltage of a transistor TW3 on a non-selected line. Hence the region to the right of Figure 2, beyond the intersection point of curves I and II showing the rise-time characteristic of the base voltage of the transistor TW3 on the selected side (for a selected line) and the fall-time characteristic of the base voltage of the transistor TW3 on the non-selected side (for a non-selected line) is a region in which the readout of information can be performed. One way to improve the rising characteristic of the curve, that is, to obtain a sharper rising characteristic, is to make the resistance of the resistor RX smaller. However, this will result in an increase in power consumption, and is not preferable. Another method would be to decrease the capacitance of the word lines, but of course, the capacitance of the words lines cannot be decreased arbitrarily.

The reason why the resistor RX is separated into two resistors, namely RX1 and RX2, is because the bases of the multi-emitter type transistors TW1 and TW2 are connected to the connecting point of these two series connected resistors RX1 and RX2, so that as a result of this connection, the amplitude (the voltage difference between the high and low states) of decoder lines *d* becomes small. Since a decoder line *d* has a large capacitance of its own, the above small amplitude is effective in speeding-up the operational speed of the device. On the other hand, the base of the transistor TW3 is connected to the power source Vcc through the resistors RX1 and RX2, and as a result of this connection, the word line thus possesses a larger amplitude than that of the decoder line *d*

$$\text{(amplitude of decoder line} = \frac{1}{\text{ratio between resistance values of resistors RX1 and RX2}}.$$

This is necessary for accurate operation of a memory cell (in a semiconductor memory device), and it is not desirable to make this amplitude too small. Accordingly, the resistor RX is separated into these two resistors RX1 and RX2, to obtain a large word line amplitude and small decoder line amplitude in order to heighten level of applicability provided by the decoder circuit and guarantee accurate and high-speed operation of a memory device.

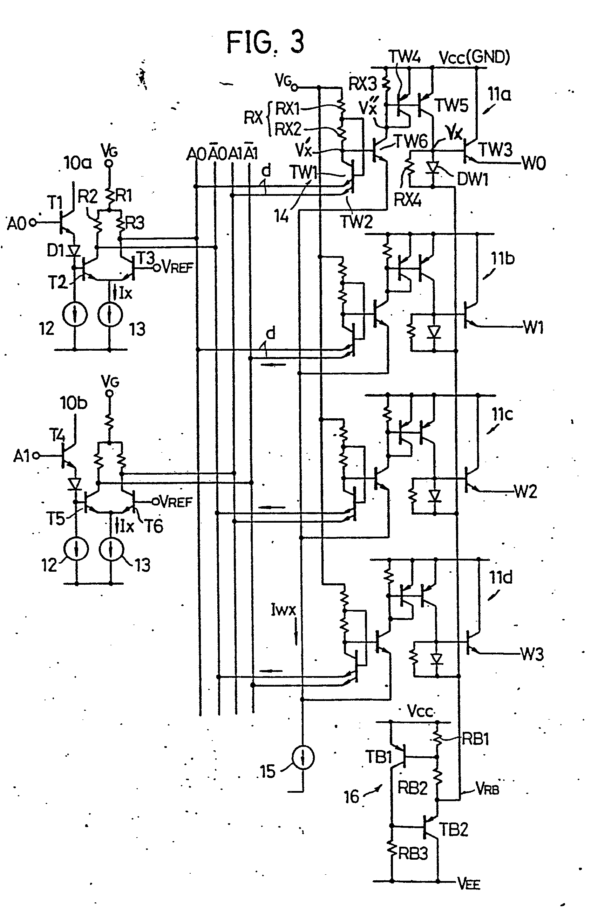

Figure 3 shows a decoder circuit embodying the present invention as applied to a two-input decoder circuit. In Figure 3, parts the same as corresponding parts in Figure 1 are designated by like reference numerals, and description thereof will be omitted:

An npn-type transistor TW6, which acts as an inverter for inverting an output VX' of AND-circuit 14, is provided in the output gate 11a (the same is true for the output gates 11b to 11d). The transistors TW6 at each output gate 11a to 11d together with a constant current source 15 provide current switches. Only the transistor TW6 of an output gate having an AND gate 14 output Vx' of high level supplied thereto becomes ON, and the level of the collector potential Vx'' of the transistor TW6 accordingly becomes low. A resistor RX3 and a first pnp-type transistor TW4 are connected in parallel between the transistor TW6 and the power source voltage Vcc (ground potential) (in each gate 11a to 11d), and the base of the transistor TW4 together with the base of a transistor TW5 are connected to the collector of the transistor TW6. As a result of these connections, the base potential Vx'' of the transistor TW5 (also the collector potential of the transistor TW6 as well as the base potential of the transistor TW4) is held at a constant potential.

The transistor TW5 is connected in series with a parallel circuit comprising a resistor RX4 and a diode DW1, between the power source voltage Vcc and a standard biasing circuit 16 (common to all gates 11a to 11d), and the potential Vx, at the connection point between the collector of the transistor TW5 and the resistor RX4, is applied to the base of the transistor (word driver) TW3 (in each gate 11a to 11d). The parallel circuit comprising the resistor RX4 and the diode DW1, together with the standard biasing circuit 16, act as a voltage clamper which clamps the high-level voltage applied to the base of the transistor TW3. This biasing circuit 16 comprises transistors TB1 and TB2, and resistors RB1 to RB3, and supplies a constant voltage VRB (−1.6 volts) to one end of resistor RX4 (of each gate 11a to 11d) as a biasing level.

The reason for employing the constant voltage circuit comprising the above transistor TW4 and the resistor RX3 will now be explained. The potential Vx'' can be considered as being equal to "Vcc−RX3 · lwx", as will be clearly seen from Figure 3, and when these values are constant, there is no need to provide separate constant potential forming means. However, these values, especially the current which flows through the resistor RX3, fluctuate due to the base current of the pnp-type transistor TW5 (also of the transistor TW4 in this example), assuming that the current lwx of the constant current source 15 is constant. Moreover, the characteristics of a pnp-type transistor, expecially β-gain, generally are very unstable, and accordingly, the base current collector current relationship fluctuates.

When the base current of the transistor TW5 is large, for example, the potential Vx' rises because the current which flows through the resistor RX3 becomes small. Hence, as a result, the base-to-emitter current of the transistor TW5 becomes small, increasing the resistance of the transistor TW5. Accordingly, not enough current is supplied to the base of the transistor (word driver) TW3 which can give rise to similar problems as those of the circuit shown in Figure 1. Therefore, the pnp-type transistor TW4 is used to prevent the above problems, by varying its conductance according to the value of the potential Vx'', to hold this potential Vx'' at a constant value.

The operation of the decoder circuit of Figure 3 will now be described for the same input conditions (A0=A1=high level), as those given for description of the circuit of Figure 1. When transistors T2 and T5 of the input gates 10a and 10b are turned ON, a current Ix flows through these transistors T2 and T5. Furthermore, a circuit comprising a power source VG and resistors R1 to R3 provided at the output stages of each of the input gates 10a and 10b, provide a current switch together with the transistors T2 and T3 (in 10a) and the constant current source Ix, and also speeds up the turning-OFF operation of the transistors TW1 and TW2 of the associated AND-circuit 14. That is, when the transistors TW1 and TW2 turn OFF, their base potential Vx' becomes equal to VG. Therefore, the decoder wiring d returns to a high-level state, being charged through the transistors TW1 and TW2 that turn OFF, when the path formed by resistors R1 to R3 is not provided, but the rising characteristic of the circuit becomes slow due to high resistance. However, when the resistors R1 to R3 are provided, charged current flows through these resistors, and speeds up the rising characteristic. Moreover, these resistors R1 to R3 prevent the high-level voltage of the decoder wiring from reaching the voltage VG, and restrains that voltage to a voltage reduced by an amount equal to the base-to-emitter voltages $V_{BE}$ of the transistors TW1 and TW2. This as a result decreases the voltage amplitude of the decoder wiring d, and helps speed up the operation of the circuit.

When the levels of the input signals A0 and A1 are both high, only the level of the output Vx' of the AND-circuit 14 in the output gate 11a becomes high. Accordingly, the transistor TW6 is turned ON, and passes a current through the power source Vcc, resistor RX3, transistor TW6, and constant current source 15 in that order. Hence, the level of the potential Vx'' becomes low, turning the transistors TW4 and TW5 ON, and the above current Iwx from the current source 15 also flows in the transistors TW4 and TW5. Thus, when the emitter area of the transistors TW4 and TW5 are equal, the same amount of current flows through the transistors TW5 as that through the transistor TW4. This current then flows into the parallel circuit having the resistor RX4 and diode DW1.

The current which flows through the resistor RX4 is in a slightly overdriven state (however, because of the clamping diode DW1, the voltage Vx is held to a voltage which is the sum of a voltage VRB and the forward voltage drop of the diode DW1), to increase the rising speed of the potential Vx, so that variation in current due to unstable α-cutoff frequency of the transistor TW5 does not affect the high-level state of the potential Vx. When the level of the potential Vx is high, the transistor (word driver) TW3 is turned into a selected state, and its emitter potential also becomes high, resulting in the selection of the word line W0 as in the case of the circuit shown in Figure 1. Furthermore, a constant biasing level voltage VRB (−1.6 volts) from the biasing circuit 16 is applied to the bases of each of the transistors (word drivers) TW3 of the output gates 11b to 11d having the transistors TW5 that are turned into the non-selected state through the resistor RX4, and thus these transistors TW3 are turned into non-selected state. Accordingly, the word lines connected to the above output gates 11b to 11d are not selected. On the other hand the charging of the word line which is selected is of course performed through the transistor TW3, and sufficient base current is supplied thereto by the transistor TW5, hence resulting in a very fast rise characteristic of the word line.

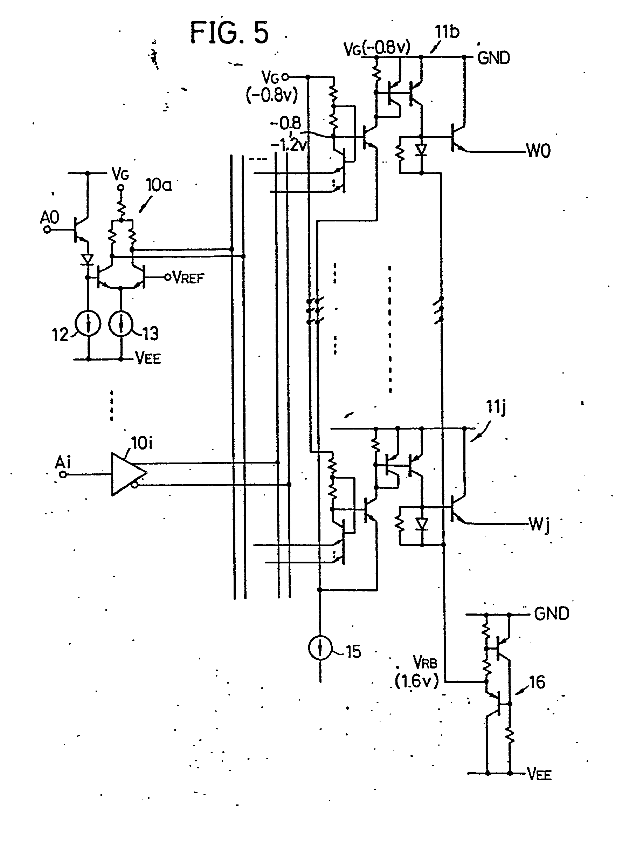

Figure 4 is a graph showing the variation in the output Vx′ of an AND-circuit 14 and the base potential Vx of the transistor (word driver) TW3. The rising characteristic of the base potential Vx is preferably one in which no sluggishness is seen as in the graph of Figure 2.

That is, generally when providing two output levels, the low or lower level is obtained by connecting a resistor to a certain potential to reduce current which flows at low level. Furthermore, the operation speed of a circuit, which provides a high-level output upon cut off of the current, becomes faster when the low-level current is drastically reduced, but the rising speed of the characteristic upon obtaining a high-level is determined by the resistor, and the capacitance effective with that resistor. The resistor RX of the circuit shown in Figure 1 corresponds to the above resistor, and as stated above, this resistor RX is of high resistance and results in a slow rising characteristic of the word line.

On the contrary, a reverse operation is performed by the circuit embodying the present invention. Accordingly, the resistor RX4 is connected to a certain potential VRB, and transistor TW5 is connected to the other end of the resistor RX4. Hence, a high level is obtained by passing a current through the above connected elements, and a low level is obtained by cutting off this current. By this operation, the value of the current can be made large since only one gate (at a time—the selected gate) provides a high-level output (the value of the current to be supplied as a whole does not become large). In the conventional system, a current is passed to each gate on the non-selected side. Thus, when the number of gates is "$n$" ($n$ is an integer), one of which is selected, the required current becomes "$n-1$" times that of the current $i$ which flows through one (non-selected) gate, and the value of this current $i$ cannot be made too large. By passing a large current by decreasing the gate resistance (resistances of transistor TW5, resistor RX4 and the like), the rising characteristic of the word line W0, that is, the base potential Vx of the transistor (word driver) TW3, can be improved.

Moreover, the amplitude of the potential Vx′ can be of any value as long as the current switch comprising the transistor TW6 and the like is operational. As shown in Figure 4, the amplitude of the potential Vx′ can be smaller than the amplitude of the potential Vx (approximately 0.4 volts is sufficient, and hence the amplitude of the decoder lines A0, $\overline{A0}$, A1, and $\overline{A1}$ are small. Accordingly, an even faster high-speed operation can be anticipated.

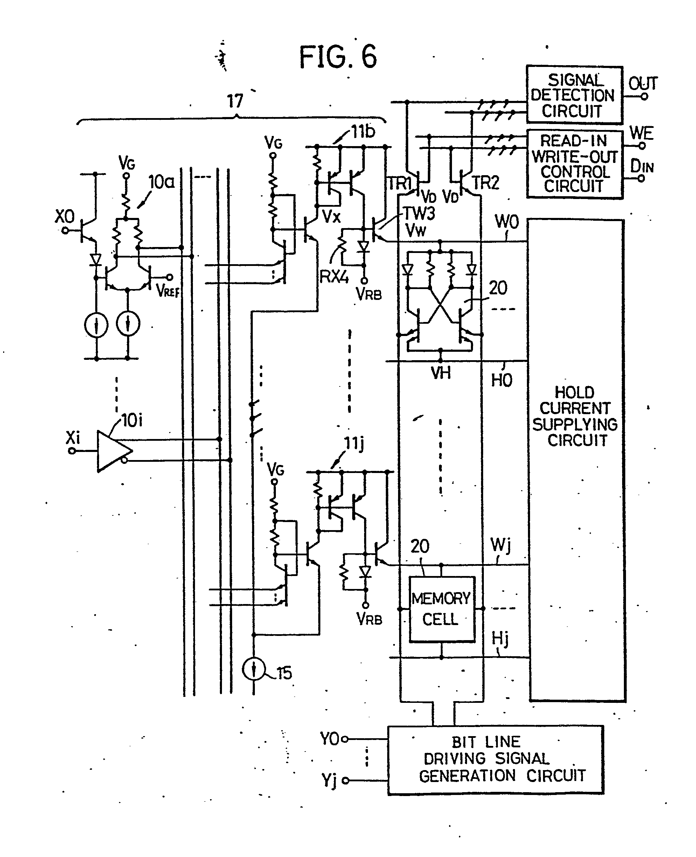

Figure 5 shows a generalised version of the circuit of Figure 3, in which input signal bits A0, A1, A2, … ,Ai are provided. Figure 6 shows an arrangement in which the decoder circuit of Figure 5 is used as a word line driving signal generation circuit (decoder driver) 17, to select a specific semiconductor memory. In Figure 6, memory cells 20 provide a memory cell array, hold lines H0 to Hj are paired with word lines W0 to Wj, and transistors TR1 and TR2 are provided for read/write operations. In this circuit, a selection current superposed with a holding current flows when the level of the base of the transistor (word driver) TW3 becomes high, and thus a relatively high current flows to the base of the transistor TW3. In order to keep supplying the above current and increase the base potential Vx at the same time, it is quite effective to pass a current through the resistor RX4 in a slightly overdriven state. That is, the rising characteristic is improved (faster rise characteristic is obtained) by using the decoder circuit of the present invention shown in Figure 5 as the decoder driver 17 of Figure 6, than using the decoder circuit of Figure 1. Especially when the capacity of the memory MEM increases, the capacitance introduced in the word lines Wo to Wj increases, increasing the load on the transistor (word driver) TW3 side. Hence, the present invention is very effective in that this load is non-existent from the point of view of the input side of the transistor (word driver) TW3.

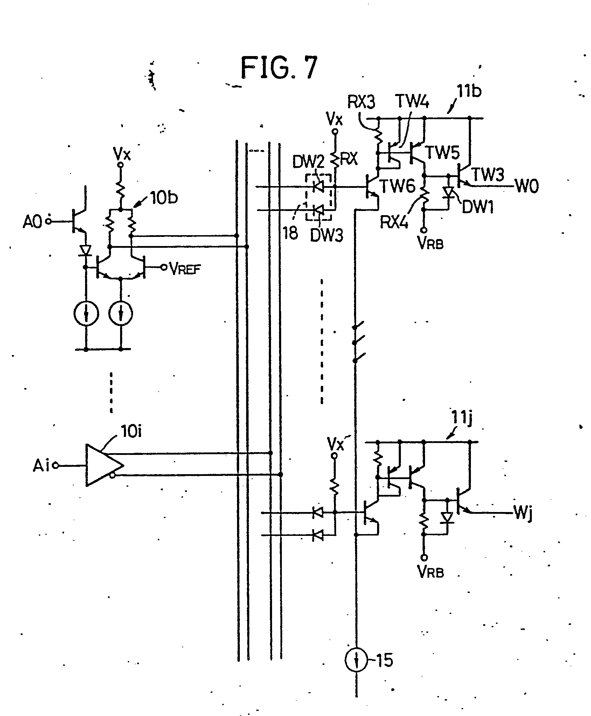

Figure 7 shows another decoder circuit embodying the present invention. In Figure 7, the point of difference from the circuits of Figures 3 and 5 is that an AND-circuit 18 of each of the output gates 11a to 11j is constructed of diodes DW2 and DW3 (diode matrix type). The remaining parts are the same and thus their description will be omitted.

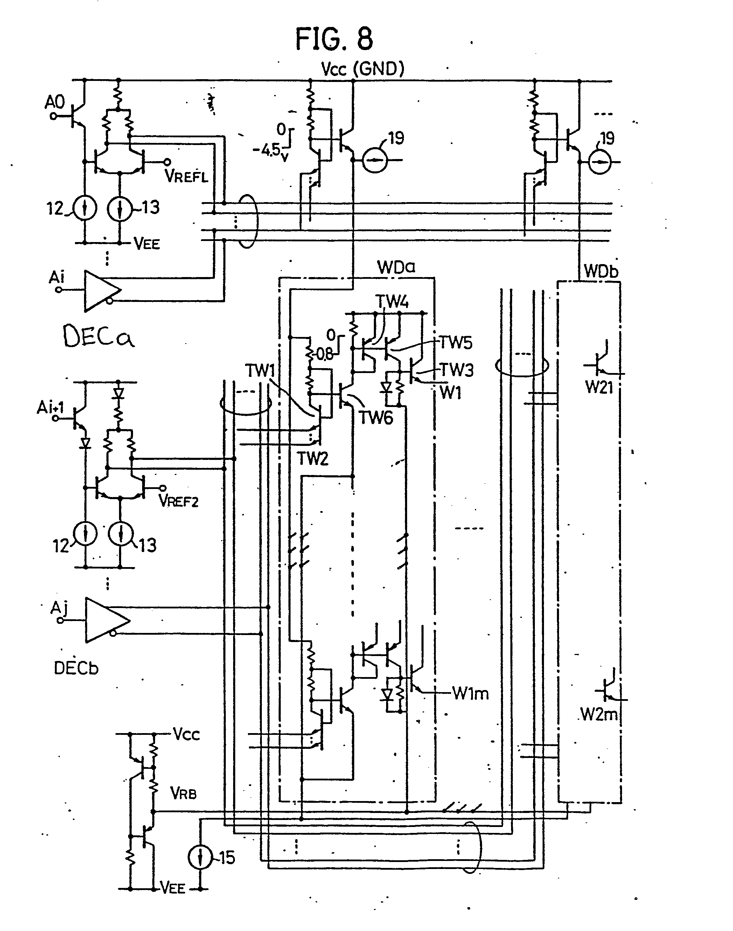

Figure 8 shows an application of a decoder circuit embodying the present invention to a two-stage decoder. In Figure 8, address signal bits are divided into a first group comprising address signal bits A0 to Ai, and a second group comprising address signal bits Ai+1 to Aj. Word lines (accordingly, word drivers as well) W11 to W1m, W21 to W2m, ..., are divided into "i+1" groups WDa, WDb, ..., each having "m" (m=j−i−1) lines. A group of decoders DECa which receives addresses A0 to Ai performs the selection of the word driver groups WDa, WDb, ..., and a group of decoders DECb which receives the addresses Ai+1 to Aj supplies address signals and their inverse signals to each of the word drivers, and selects each of the word drivers. Accordingly, the decoder circuit of the present invention, as shown within the word driver group WDa of Figure 8, can be applied to a two-stage (or three-stage) decoders.

## Claims

1. A decoder circuit, having an output gate (11a to 11d; 11j) with an emitter follower output driver (TW3) for selectively driving an output line (W0 to W3; Wj; W1 to W1m, W2 to W2m) of the decoder circuit in dependence upon a logic input supplied to the output gate (11a to 11d; 11j), and current switching means (TW4, TW5, TW6, RX3), comprising a PNP transistor TW5), electrically connnected between a voltage source (Vcc, GND; VG) and the base of the output driver (TW3), for switching current from the voltage source (Vcc, GND; VG) to the base of the output driver (TW3) when the logic input has a value indicating that the output line (W0, to W3; Wj; W1 to W1m, W21 to W2m) is to be driven, characterised in that the current switching means further comprises a constant voltage maintaining means including a transistor (TW4) and a resistor (RX3) connected in parallel, the base of the said transistor (TW4) being connected to the base of the PNP transistor (TW5) to stabilise the current fed to the base of the output driver.

2. A circuit as claimed in claim 1, wherein the current switching means further includes an inverter (TW6) connected to receive the logic input.

3. A circuit as claimed in claim 1 or 2, further comprising voltage clamping means (RX4, DW1) arranged for clamping the voltage applied to the output driver (TW3), and biasing means (16) electrically connected to the voltage clamping means (RX4, DW1).

4. A circuit as claimed in claim 1, 2 or 3, further comprising a logic circuit, for supplying the said logic input, comprising a multi-emitter transistor (TW1, TW2,) arranged for operating as an AND circuit (14) with respect to selection signals (A0, $\overline{A0}$, A1, $\overline{A1}$) delivered to the emitters thereof.

5. A circuit as claimed in claim 1, 2 or 3, further comprising a logic circuit, for supplying the said logic input, comprising diodes (DW2, DW3) arranged for operating as an AND circuit (18) with respect to selection signals delivered to the diodes.

6. A circuit as claimed in any preceding claim, comprising a plurality of such output gates (11a to 11d; 11j).

7. A circuit as claimed in claim 6, further comprising a plurality of input gates (10a, 10b, 10i) operable to receive respective input signals (A0, A1, Ai, X0, Xi, Ai+1, Aj) and to provide such input signals and their inverses, for use as selection signals for delivery to logic circuits (14, 18) which provide the logic inputs for the output gates (11a to 11d; 11j).

8. A semiconductor memory device including a decoder circuit as claimed in any preceding claim, the or each output line (W0 to W3; Wj, W1 to W1m, W21 to W2m) of the decoder circuit being a word line of the memory device.

## Patentansprüche

1. Dekodierschaltung, mit einem Ausgangsgatter (11a bis 11d; 11j) mit einem Emitterfolge - Ausgangstreiber (TW3) zum selektien Treiben einer Ausgangsleitung (W0 bis W3; Wj; W1 bis W1m, W2 bis W2m) der Dekodierschaltung in Abhängigkeit von einem logischen Eingang, der dem Ausgangsgatter (11a bis 11d; 11j) zugeführt wird, und einer Stromschalteinrichtung (TW4, TW5, TW6, RX3), mit einem PNP-Transistor (TW5), der elektrisch zwischen einer Spannungsquelle (Vcc, GND; VG) und der Basis des Ausgangstreibers (TW3) angeschlossen ist, um den Strom von der Spannungsquelle (Vcc, GND; VG) zu der Basis des Ausgangstreibers (TW3) zu schalten, wenn der logische Eingang einen Wert hat, der anzeigt, daß die Ausgangsleitung (W0 bis W3; Wj; W1 bis W1m, W21 bis W2m) getrieben werden soll, dadurch gekennzeichnet, daß die Stromschalteinrichtung ferner eine Konstantspannungs - Aufrechterhaltungseinrichtung umfaßt, die einen Transistor (TW4) und einen Widerstand (RX3) umfaßt, die parallel angeschlossen sind, die Basis des genannten Transistors (TW4) mit der Basis des PNP-Transistors (TW5) verbunden ist, um den zu der Bais des Ausgangstreibers geführten Strom zu stabilisieren.

2. Schaltung nach Anspruch 1, bei welcher die Stromschalteinrichtung ferner einen Inverter (TW6) umfaßt, der zum Empfang des logischen Eingangs angeschlossen ist.

3. Schaltung nach Anspruch 1 oder 2, ferner mit einer Spannungsklemmeinrichtung (RX4, DW1), die zum Klemmen der Spannung angeordnet ist, die dem Ausgangstreiber (TW3) zugeführt wird, und einer Vorspannungseinrichtung (16), die elektrisch mit der Spannungsklemmeinrichtung (RX4, DW1) verbunden ist.

4. Schaltung nach Anspruch 1, 2 oder 3, ferner mit einer logischen Schaltung zum Zuführen des genannten logischen Eingangs, mit einem Multiemittertransistor (TW1, TW2, der zum Betrieb als eine UND-Schaltung (14) in Bezug auf die Auswahlsignale (A0, $\overline{A0}$, A1, $\overline{A1}$) angeordnet ist, die seinen Emittern zugeführt werden.

5. Schaltung nach Anspruch 1, 2 oder 3, ferner mit einer Logikschaltung zum Zuführen des genannten Logischen Eingangs, welche Dioden (DW2, DW3) umfaßt, die zum Betrieb als eine UND-Schaltung (18) in Bezung auf die den Dioden zugeführten Auswahlsignale angeordnet sind.

6. Schaltung nach einem der vorhergehenden Ansprüche, mit einer Vielzahl von logischen Ausgangsgattern (11a bis 11d; 11j).

7. Schaltung nach Anspruch 6, mit einer Vielzahl von Eingangsgattern (10a, 10b, 10i), die betreibbar sind, um jeweilige Eingangssignale (A0, A1, Ai, X0, Xi, Ai+1, Aj) zu empfangen und um solche Eingangssignale und die Inversen davon zu liefern, zur Verwendung als Auswahlsignale zur Zuführung zu den Logikschaltungen (14, 18), die die logischen Eingänge für die Ausgangsgatter (11a bis 11d; 11j) liefern.

8. Halbleiterspeichervorrichtung mit einer Dekoderschaltung nach einem der vorhergehenden Ansprüche, wobei die oder jede Ausgangsleitung (W0 bis W3; Wj, W1 bis W1m, W2l bis W2m) der Dekodierschaltung eine Wortleitung der Speichervorrichtung ist.

**Revendications**

1. Circuit de décodage, possédant une porte de sortie (11a à 11d; 11j) dotée d'un dispositif d'excitation de sortie à èmetteur suiveur (TW3) servant à sélectivement exciter une ligne de sortie (W0 à W3; Wj; W11 à W1m, W21 à W2m) du circuit de décodage en fonction d'un signal d'entrée logique délivré à la porte de sortie (11a à 11d; 11j), et un moyen de commutation de courant TW4, TW5, TW6, RX3), comprenant un transistor pnp (TW5), qui est électriquement connecté entre une source de tension (Vcc, la terre; VG) et la base du dispositif d'excitation de sortie TW3), afin de commuter le passage d'un courant de la source de tension (Vcc, la terre; VG) à la base du dispositif d'excitation de sortie (TW3) lorsque le signal d'entrée logique posséde une valeur indiquant que la ligne de sortie (W0 à W3; Wj; W11 à W1m, W21 à W2m) doit être excitée, caractérisé en ce que le .oyen de commutation de courant comprend en outre un moyen qui maintient la tension constante comportant un transistor (TW4) et une résistance (RX3) connectées en parallèle, la base dudit transistor (TW4) étant connectée à la base du transistor pnp (TW5) afin de stabiliser le courant fourni à la base du dispositif d'excitation de sortie.

2. Circuit selon la revendication 1, où le moyen de commutation de courant comprend en outre un inverseur (TW6) connecté de façon à recevoir le signal d'entrée logique.

3. Circuit selon la revendication 1 ou 2, comprenant en outre un moyen de verrouillage de tension (RX4, DW1) disposé de manière à verrouiller la tension appliquée au dispositif d'excitation de sortie (TW3), et un moyen de polarisation (16) électriquement connecté au moyen de verrouillage de tension (RX4, DW1).

4. Circuit selon la revendication 1, 2 ou 3, comprenant en outre un circuit logique, servant à délivrer ledit signal d'entrée logique, comprenant un transistor à plusieurs émetteurs (TW1, TW2) disposé de façon à fonctionner en circuit ET (14) relativement à des signaux de sélection (A0, $\overline{A0}$ A1, $\overline{A1}$) délivrés à leurs émetteurs.

5. Circuit selon la revendication 1, 2 ou 3, comprenant en outre un circuit logique, servant à délivrer ledit signal d'entrée logique, comprenant des diodes (DW2, DW3) disposées de façon à fonctionner en circuit ET (18) relativement à des signaux de sélection délivrés aux diodes.

6. Circuit selon l'une quelconque des revendications précédentes, comprenant plusieurs semblables portes de sortie (11a à 11d; 11j).

7. Circuit selon la revendication 6, comprenant en outre plusieurs portes d'entrée (10a, 10b, 10i) ayant pour fonction de recevoir des signaux d'entrée respectifs (A0, A1, Ai, X0, Xi, Ai+1, Aj), et de produire de semblables signaux d'entrée et leurs inverses, afin de les utiliser comme signaux de sélection devant être délivrés à des circuits logiques (14, 18) qui produisent les signaux d'entrée logiques destinés aux portes de sortie (11a à 11d; 11j).

8. Dispositif de mémoire à semiconducteurs comportant un circuit de décodage selon l'une quelconque des revendications précédentes, la ligne de sortie ou chaque ligne de sortie (W0 à W3; Wj, W11 à W1m, W21 à W2m) du circuit de décodage étant une ligne de mot du dispositif de mémoire.

FIG. 1

FIG. 2

FIG. 4

# FIG. 3

# FIG. 5

# FIG. 6

# FIG. 7

# FIG. 8